Europäisches Patentamt

European Patent Office

Office européen des brevets

(19)

(11) Publication number: 0 308 963
A2

# EUROPEAN PATENT APPLICATION

(12)

(21) Application number: 88115699.6

(22) Date of filing: 23.09.88

(51) Int. Cl.4: H03M 7/18 , G06F 7/72

(30) Priority: 25.09.87 JP 238856/87

(43) Date of publication of application:
29.03.89 Bulletin 89/13

(84) Designated Contracting States:
DE FR GB

(71) Applicant: KABUSHIKI KAISHA TOSHIBA
72, Horikawa-cho Saiwai-ku
Kawasaki-shi Kanagawa-ken 210(JP)

(72) Inventor: Kawamura, Shinichi
Toshibakamiookaryo 2-14-1 Okubo Konan-ku
Yokohama-shi Kanagawa-ken(JP)
Inventor: Hirano, Kyoko 104 Totsukagreenhill
Diamond Mansion
2420-6 Kamiyabe-cho Totsuka-ku
Yokohama-shi Kanagawa-ken(JP)

(74) Representative: Lehn, Werner, Dipl.-Ing. et al
Hoffmann, Eitle & Partner Patentanwälte
Arabellastrasse 4
D-8000 München 81(DE)

(54) Remainder computing system and method.

(57) A remainder computing system computes a remainder of a base "a" number M or "n" digits with respect to a base "a" modulus N of "q" digits by repeatedly using predetermined means. The system comprises a remainder table storing remainders of base "a" numbers each of "b" digits with respect to the modulus N, and an adder for separating a block X of "b" digits from the number M to leave a remaining portion Z, finding a remainder corresponding to the block X in the remainder table, aligning a least significant position of the remainder with a least significant position of the block X, and adding the aligned remainder to the remaining portion Z. A value obtained from the adder is set as a new number M to be processed.

Since the remainders of the base "a" numbers each of "b" digits are calculated and stored in the remainder table in advance, a remainder for any block X of "b" digits picked up from a most significant position of the number M can be found in the remainder table with no calculation. The remainder table is repeatedly used for processing a value obtained from the adder.

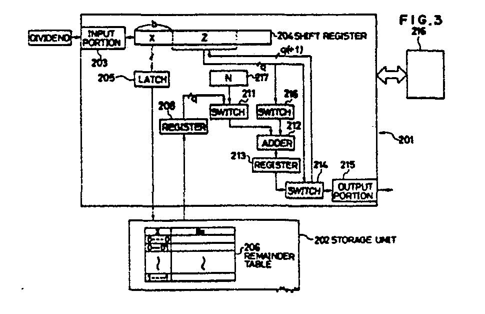

FIG.3

## REMAINDER COMPUTING SYSTEM AND METHOD

### BACKGROUND OF THE INVENTION

#### Field of the Invention

The present invention relates to a remainder computing system for finding remainders of optional numbers with respect to a predetermined modulus, and particularly to a remainder computing system which is able to compute the remainders at high speed with small memory capacity.

#### Description of the Prior Art

In recent years, the use of encryptions has been studied to protect information against illegal access, wiretapping and alteration. Among various encryption techniques, a public key encryption system is advantageous because it can conceal the information and verify the writer of a message, i.e., it has a digital signature function.

The most promising public key encryption system to be used for IC cards, etc., may be an RSA public key encryption.

In the RSA public key encryption, a message M, an encrypted message C and encryption keyps c, d and n known by an authorized person are encrypted and decoded with the following algorithms:

$C = M^e \bmod n$ (encrypting)
$M = C_d \bmod n$ (decoding)

For the stength of encryption, it is considered that the key n is preferable to be a positive integer of two hundred decimal digits or more. However, as the key n becomes larger, an amount of computation will be increased.

A particularly time consuming portion of the encrypting and decripting algorithms is:

$R = M1 \times M2 \bmod n.$

To compute this at high speed, there is a conventional method which will be explained with reference to Fig. 1.

The conventional method shown in the figure computes a remainder of a number M (= M1 x M2) with respect to a modulus n at high speed. A portion of the number M which is larger than the modulus n is divided into blocks r1, r2 and r3 each of several bits.

Remainders of the blocks r1, r2 and r3 with respect to the modulus n are stored in advance in remainder tables RAM1, RAM2 and RAM3, respectively. Therefore, remainders R1, R2 and R3 corresponding to the blocks r1, r2 and r3 are read out of the tables RAM1, RAM2 and RAM3 and added to Z which is a portion of the number M smaller than the modulus n, to reduce the number M. This operation is repeated until a remainder of the number M is found.

The details of this technique is reported in "A Study of RSA Split Computing Process" in "Encryption and Information Security Workshop Lecture Papers 1986" by Naoya Torii, Mitsuhiro Higashi and Ryota Akiyama.

This conventional technique reduces M (= M1 x M2) by using the remainder tables to execute the remainder computation at high speed. However, it has a drawback that the remainder tables shall have enormous capacities, respectively. Supposing the key n is 512 bits and a dividend 1024 bits, the upper 512 bits of the dividend are divided into blocks each of several bits, and remainder tables shall be prepared for the blocks, respectively. If the length of one block is four bits, the number of blocks will be 128 so that 128 remainder tables shall be prepared. As a result, the remainder tables may require a memory of one megabit or more.

If the length of each block is extended, the remainder tables may require less memory, but a computation speed will be reduced. Further, if the size of each remainder table is large, it is laborsome to rearrange the table when the modulus n is changed.

There is another conventional method to obtain a remainder at high speed. This method uses a multiplication table to efficiently solve division problems. For example, a multiplication table for base $2^k$ numbers is prepared with respect to divisions by the base $2^k$ numbers to find remainders. This method is disclosed in Japanese Patent Publication No. 62-11937.

According to this method, a time necessary for the computation of a remainder is substantially inverse proportion to the parameter k. Therefore, a processing speed may be increased by increasing the parameter k. However, the size of the multiple table is substantially increased proportional to $2^k$. Namely, the size of the multiple table is exponentially increased as the parameter k increases. However, due to hardware limits, the parameter k cannot drastically be enlarged to increase the processing speed.

As described in the above, according to the conventional remainder computing systems, remainders of respective digits of numbers whose remainders are to be found shall be stored in advance in memories. Therefore, the capacity of each memory shall be increased considerably as each number which is subjected to the remainder computation becomes large, thus increasing the size and cost of hardware.

## SUMMARY OF THE INVENTION

An object of the present invention is to provide a remainder computing system which can perform a high speed remainder computation with a small storage means.

Another object of the present invention is to provide a remainder computing system which can perform a high-speed remainder computation with a simple remainder computation procedure.

According to an aspect of the present invention, there is provided a remainder computing system for computing a remainder (Ri) of a base "a" number (M1) of "n" digits with respect to a base "a" modulus (N) of "q" digits. This system comprises:

(i) a storage means storing remainders of base "a" numbers each of "b" digits with respect to the modulus (N); and

(ii) a means for separating a block (X1) of "b" digits from a most significant position of the number (M1) to leave a remaining portion (Z), finding a remainder (R1) corresponding to the block (X1) in the storage means, aligning a least significant position of the remainder (R1) with a most significant position of the remaining portion (Z) to obtain a number (R1q), and adding the remaining portion (Z) to the number (R1q).

According to another aspect of the present invention, there is provided a remainder computing method for computing a remainder (Ri) of a base "a" number (M1) of "n" digits with respect to a base "a" modulus (N) of "q" digits. This method comprises the steps of:

(i) separating a block (X1) of "b" digits from a most significant position of the number (M1) to leave a remaining portion (Z);

(ii) finding a remainder (R1) of the block (X1) with respect to the modulus (N) in a storage means which is storing in advance remainders of base "a" numbers each of "b" digits with respect to the modulus (N);

(iii) aligning a least significant position of the remainder (R1) with a most significant position of the remaining portion (Z) to obtain a number (R1q);

(iv) adding the remaining portion (Z) to the number (R1q); and

(v) if the number of digits of the added results is larger than the number "b", setting the added result as a new number (M2) to repeat the steps (i), (ii), (iii) and (iv) on the new number (M2), and, if the number of digits of the added result is equal to or smaller than the number "b," outputting the added result as the final remainder (Ri).

These and other objects, features and advantages of the present invention will become apparent from the following descriptions of preferred embodiments taken in conjunction with the accompanying drawings.

## BRIEF DESCRIPTION OF THE DRAWINGS

Fig. 1 is a block diagram showing the principle of remainder computation with the use of remainder tables according to a prior art;

Fig. 2 is a block diagram showing the principle of remainder computation according to the present invention;

Fig. 3 is a view showing a remainder computing system based on the remainder computation of Fig. 2 according to the present invention;

Fig. 4 is a block diagram showing the principle of another remainder computation according to the present invention; and

Fig. 5 is a view showing a remainder computing system based on the remainder computation of Fig. 4 according to the present invention.


## DETAILED DESCRIPTION OF THE EMBODIMENTS

Before describing embodiments of the present invention, a concrete example of the first prior art remainder computation of Fig. 1 will be described for better understanding the principle of the present invention which will be explained later.

In this example, a remainder (R) of a dividend (M1 x M2 = 2048) with respect to a key (modulus) (n = 7) is going to be found. The remainder can be expressed as follows:

R = M1 x M2 mod n

= 2048 mod 7     (1)

In this example, the key (n) is of one decimal digit and the dividend (M1 x M2) is of four decimal digits for the sake of simplicity. However, these are large numbers with many digits in practice.

The equation (1) will be resolved with the use of the following formulae to obtain an expression (2). Note that "mod n" in the following formulae has two meanings; ① a binary operator for finding a remainder with respect to the modulus (n), and ② a congruent relation with respect to the modulus "n".

(a + b) mod n ≡ (a mod n + b mod n) (mod n)

(a • b) mod n ≡ (a mod n) • (b mod n) (mod n)

R = 2048 mod 7

≡ (2000 mod 7 + 000 mod 7 + 40 mod 7 + 8) (mod 7)     (2)

Meanwhile, the following remainder table is prepared in advance for the second, third and fourth digits.

| Value | Fourth (RAM1) | Third (RAM2) | Second (RAM3) |
|---|---|---|---|
| 1 | 6 | 2 | 3 |
| 2 | 5 | 4 | 6 |
| 3 | - | - | 2 |
| 4 | - | - | 5 |
| 5 | - | - | 1 |
| 6 | - | - | 4 |
| 7 | 0 | 0 | 0 |
| 8 | - | - | 3 |
| 9 | - | - | 6 |
| 0 | 0 | 0 | 0 |

In this table, a figure 6 in the column of the fourth digit for the value 1 is obtained from the calculation of "1000 mod 7 = 6." Similarly, a figure 5 in the column of the fourth digit for the value 2 is obtained from the calculation of "2000 mod 7 = 5," and a figure 2 in the column of the third digit for the value 1 is obtained from the calculation of "100 mod 7 = 2." Generally, a figure in the column of "a"th digit for a value "v" is obtainable from the calculation of "$(v \times 10^8)$ mod 7" (in the case of decimal notation).

With the use of this table, the equation (2) will be modified as follows:

R

≡ (2000 mod 7 + 000 mod 7 + 40 mod 7 + 8) (mod 7)

≡ (5 + 0 + 5 + 8) (mod 7)

≡ 18 mod 7

≡ (10 mod 7 + 8) (mod 7)

≡ (3 + 8) (mod 7)

≡ 11 (mod 7)

≡ (10 mod 7 + 1) (mod 7)

≡ (3 + 1) (mod 7)

≡ 4 (mod 7)     (3)

4

This modification is carried out; ① the dividend is resolved into components based on respective digits, ② remainders of the respective components with respect to the modulus 7 are found (mod 7), ③ the remainders can be found in the contents of the table, ④ the sum of the found remainders is calculated, and ⑤ the procedure is repeated from ①. Finally, the remainder R can be obtained by calculating the equation (3).

According to this point art method, the number of RAMs needed for the table increases as the numbers of bits of the dividend (M1 x M2) and key (n) increase. However, the number of bits of the dividend (M1 x M2) and key (n) shall sufficiently be large to provide strong encryption.

Now, the principle of the present invention which can improve a remainder computation speed will be explained.

In the following explanation, a solution of "X mod N" is going to be calculated. Generally, in calculating "X mod N," a quotient Q is found by dividing the dividend X by the divisor N, and "X mod N" is found through the calculation of "X - N · Q."

Although the multiplication of large numbers can be executed at high speed with parallel hardware, there is no parallel procedure for the division of large numbers so that the division takes a long time to carry out to hinder a high-speed operation.

Not directly computing the division, the present invention keeps a congruent relation "$X_j \equiv X \pmod N$" with respect to the modulus N, and modifies the relation from "$X = X_0$" to $X_0 \to X_1 \to X_2 \to$ ... ($X_0 > X_1 > X_2$ ...) to reduce the number of digits at high speed. Generally, from a value $X_j$ of step j, a value $X_{j+1}$ of step j+1 satisfying the following equation is found at high speed;

$X_j \equiv X_{j+1} \pmod N \ (X_j > X_{j+1})$ 　　(4)

By dividing the value $X_j$ into blocks $X^{(i)}$ (i = 1, 2, ..., $\ell j$) each of b ($\geqq$ 2) bits, the following is obtained:

$$X_j = \sum_{i=1}^{\ell j} X_j^{(i)} \cdot 2^{b(i-1)} \qquad \cdots(5)$$

Here, $X_{j+1}$ is defined as follows:

$$X_{j+1} = \sum_{i=1}^{\ell j - 1} X_j^{(i)} \cdot 2^{b(i-1)} + (X_{\ell j}^{(j)} \cdot 2^q \bmod N) \cdot 2^{t j} \qquad \cdots(6.1)$$

$tj = b \cdot (\ell j - 1) - q$ 　　(6.2)

The equation (6.1) is obtained by operating "mod N" with respect to only the most significant block $X^{(i)}$. Here, "q" is the number of bits of modulus N and $tj \geqq 0$. The equation (5) and (6.1) satisfy the equation (4). This will be demonstrated hereunder.

$X_j - X_{j+1}$
$= X_{\ell j}^{(j)} \cdot 2^{b(\ell j-1)} - (X_{\ell j}^{(j)} \cdot 2^q \bmod N) \cdot 2^{tj}$ 　　(7)

If the right side of the equation (7) is positive and is a multiple of N, it will be demonstrated that $X_j$ and $X_{j+1}$ defined in the equations (5) and (6.1) have the relation expressed with the equation (4). For this demonstration, it is supposed:

$X_{\ell j}^{(j)} \cdot 2^q \bmod N = r \ (0 \leqq r \leqq N-1)$

Then, according to the definition of mod, a certain positive integer "k" exists to establish the following equation:

$X_{\ell j}^{(j)} \cdot 2^q = k \cdot N + r$ 　　(8)

Both sides of the equation (8) are multiplied by "$2^{tj} = 2^{b(\ell j - 1) - q}$" to obtain the following:

$X_{\ell j}^{(j)} \cdot 2^q \cdot 2^{tj} = (k \cdot N + r) \cdot 2^{tj}$
$X_{\ell j}^{(j)} \cdot 2^{b(\ell j - 1)} = k \cdot N \cdot 2^{tj} + r \cdot 2^{tj}$ 　　(9)

The second term of the right side of the equation (9) is transferred to the left side and compared with the equation (7) to obtain the following:

$X_j - X_{j+1} = 2^{tj} \cdot k \cdot N > 0$ 　　(10)

$\therefore X_j \equiv X_{j+1} \pmod N \ (X_j > X_{j+1}$ 　　(11)

This, it has been demonstrated that $X_j$ and $X_{j+1}$ satisfy the equation (4).

To obtain a solution of the equation (6.1) at high speed when the equation (5) is given, the mod operation of the second term of the equation (6.1) may be computed and stored in a RAM in advance. If the

value $X_j$ has $\ell j$ bits, the value $X_{j+1}$ has only "$b\ell j-b+1$" bits. Namely, through one time of table lookup and addition, the remainder computation can be reduced at least by "b-1" bits. From this, is is understood that the size of X can be reduced at high speed by repeating the table lookup and addition.

For example, if $X_j$ has "m" bits, $X_{j+1}$ may have "m-b+1" bits or smaller bits. The upper "b" bits of $X_{j+1}$ are used as an address to look up the table again, and the number of bits of $X_{j+1}$ may be reduced by about "b-1" bits to have "m-2(b-1)" bits or smaller bits.

The table lookup is continued until $X_j$ is reduced to a value smaller than the modulus N so that the computation of "X mod N" can be done at high speed.

How to prepare the RAM table will be explained.

According to the equation (6.1), the RAM table shall have values "$X^{(\ell_j)} \cdot 2^q \cdot \mod N$" which shall be calculated and stored in advance. Since $X^{(\ell_j)}$ is a block of "b" bits, "$X^{(\ell_j)} \cdot 2^q$" will only be "$2^b$" numbers. Further, the values "$X^{(\ell_j)} \cdot 2^q \mod N$" are each of at most "q" bits (equal to the number of bits of N). Therefore, the RAM is constituted such that the values "$X^{(\ell_j)} \cdot 2^q \mod N$" are read out from the RAM with addresses $X^{(j)}$. Therefore, the capacity of the RAM will be "$q \cdot 2^b$" bits. This table constitution is the most typical one.

According to this method, the table size will be increased exponentially as the parameter "b" becomes larger. To avoid this problem, $X^{(j)}$ may be divided into plural segments, and a plurality of tables are prepared. This method will be explained in detail.

Each block of "b" bits is divided into $\lceil b/S \rceil$ segments ($\lceil \ \rceil$ means a round-up) each of S bits. Each segment is represented with a reference mark $\epsilon$ k. Namely, it is supposed as follows:

$$X(j) = \sum_{k=1}^{\lceil b/S \rceil} \xi k \cdot 2^{s(k-1)}$$

A table is constituted such that:

$\epsilon_k \cdot 2^{s(k-1)} \cdot 2^q \mod N$

can be read with the segments $\epsilon$ k as addresses. A table for each segment needs "q bits x $2^s$ words." Therefore, required total memory capacity is "$\lceil b/S \rceil \cdot q \cdot 2^s$" bits. Paying attention to "$2^{b/s} > \lceil b/S \rceil$," it is understood that the memory capacity can always be reduced by dividing a table into plural tables. However, a number of bits to be reduced from the number of bits of $X_j$ will be "$b-(\lfloor \log_2 \lceil b/S \rceil \rfloor + 1)$" bits in the worst case.

Figure 2 is a block diagram showing a remainder computation method according to the first principle of the present invention.

In the figure, a modulus N has "q" digits, and a dividend M is firstly set as a number M1. A block X1 of "b" digits is picked up from the most significant bit (MSB) of the number M1 to leave a portion Z1. A remainder R1 corresponding to the block X1 is read out of a RAM which is storing necessary remainders. The remainder R1 read out of the RAM is aligned with the remaining portion Z1, and they are added to each other. In aligning them with each other, the lowest position of the remainder R1 is aligned with the "q"th position from the highest position of the remaining portion Z1. This alignment can easily be done by shifting the remainder R1 and simply realized in hardware.

The added result is set as a number M2 which is subjected to the same process as that for the number M1. The process is repeated until the number to be processed becomes smaller than the modulus N.

An embodiment of the present invention according to the principle explained in the above will be described in comparison with the concrete example according to the first prior art method.

A solution of the following remainder equation will be found:

Ri = X mod n

= 2048 mod 7

This equation can be resolved as follows:

Ri = 2048 mod 7

= (20 x 100 + 048) mod 7

= {(20 mod 7) x 100 + 48} (mod 7)     (12)

Here, a remainder table for the second digit numbers is prepared in advance as follows:

| Value | Second (RAM) |
|-------|--------------|
| 1 | 3 |
| 2 | 6 |
| 3 | 2 |
| 4 | 5 |
| 5 | 1 |
| 6 | 4 |
| 7 | 0 |
| 8 | 3 |
| 9 | 6 |
| 0 | 0 |

It shall be noted that the prior art has prepared tables for the third digit numbers and the fourth digit numbers, but this example of the present invention needs only a table for the second digit numbers.

According to this table, the equation (12) will be modified as follows:

$$Ri \equiv \{(20 \bmod 7) \times 100 + 48\} \pmod 7$$
$$\equiv (6 \times 100 + 48) \pmod 7 \qquad (13)$$

This equation (13) can be resolved as follows:

$$Ri \equiv (6 \times 100 + 48) \pmod 7$$
$$\equiv 648 \pmod 7$$
$$\equiv (60 \times 10 + 48) \pmod 7 \qquad (14)$$
$$\equiv \{(60 \bmod 7) \times 100 + 48\} \pmod 7 \qquad (14')$$

With the use of the remainder table, the equation (14') can be expressed as follows:

$$Ri \equiv \{(60 \bmod 7) \times 100 + 48\} \pmod 7$$
$$\equiv (4 \times 10 + 48) \pmod 7$$
$$\equiv 88 \pmod 7$$
$$\equiv (80 + 8) \pmod 7$$
$$\equiv \{(80 \bmod 7) + 8\} \pmod 7$$
$$\equiv (3 + 8) \pmod 7$$
$$\equiv 11 \bmod 7$$
$$\equiv \{(10 \bmod 7) + 1\} \pmod 7$$
$$\equiv (3 + 1) \pmod 7$$
$$\equiv 4 \bmod 7 \qquad (15)$$

Then, the remainder $Ri$ can be obtained by calculating the equation (15). Namely, according to the method of the present invention, only the remainder table for the second digit numbers is necessary so that the small remainder table is sufficient to perform a high-speed remainder computation.

Figure 3 is a view showing a remainder computing system according to the method of the present invention explained in the above. In the figure, "q" is the number of digits of modulus N.

The system comprises a computing unit 201 for carrying out a remainder computation, and a storage unit (RAM) 202 which stores a remainder table. The remainder table stored in the storage unit 202 contains remainders $Ri$ of different numbers ($a^b$ pieces) each of base "a" of "b" digits.

A dividend M is inputted into an input portion 203, written in a shift register 204 and left-justified in the register 204. An upper block X1 of "b" digits of the data M written in the register 204 is used to look up the table stored in the storage unit 202. Namely, the block X1 is latched in a latch circuit 205 and outputted as an address for looking up the table to the storage unit 202.

The storage unit 202 comprises a remainder table 206 and outputs a remainder R1 corresponding to the block X1 to a register 208.

On the other hand, the block X1 of upper "b" digits in the register 204 is cleared from the register 204 to leave a portion Z composed of lower n digits excluding the block X1 of the dividend M. A block of "q" digits from the most significant bit of the portion Z is transferred to an adder 212 via a switch 216. In the adder 212, the block "q" digits and the remainder R1 are added to each other, and the added result (S1) is obtained in a register 213. In performing this adding operation, the remainder R1 from the storage unit 202 is aligned with the block of "q" digits from the portion Z and added to it. Examples of this aligning operation are "6 x 100" in the equation (13) and "60 x 10" in the equation (14).

The added result S1 in the register 213 is transferred to the upper "q"th position of the portion Z in the shift register 204 via a switch 214. The added result S1 will have at most "q + 1" digits. In this case, the extra most significant digit of the value S1 is placed at the upper "b"th position (the least significant position of the block X1) of the register 204. Since data below the upper "b + q"th digit of the shift register 204 are not affected by the above operation, the adder may be of substantially "q" digits.

Then, the contents of the shift register 204 will be set as M2. A control position (not shown) shifts the contents of the shift register 204 toward the left to left-justify the value M2. The controller (not shown) checks to see whether or not an effective number of digits of M2 is smaller than "q + b." If it is larger than "q + b," the value M2 is set as a new dividend and processed.

The upper "b" bits of the dividend M2 is picked up as a block X2 to leave a remaining portion 22. The block X2 is supplied to the storage unit 202 via the latch 205. A remainder R2 corresponding to the block X2 is read out of the remainder table 206 and transferred to the register 208. Then, the block X2 is cleared from the register 204, and the upper "q" digits of the remaining portion Z2 is applied to the adder 212 via the switch 216. In the adder 212, the upper "q" digits of the portion Z2 and the remainder R2 from the register 208 are added to each other to obtain an added result S2. The added result S2 is written in the upper "q" digits (or "q + 1" digits) of the register 204. Then, the contents of the register 204 are set as a new dividend M3 and left-justified. A block X3 of upper "b" digits of the dividend M3 is picked up.

If the digit number "n" of M3 is larger than "q + b," the controller repeats the same process with the new dividend M3. However, if the number of digits of M3 is less than "q + b," the process of looking up the table is terminated. If the process is terminated, the value M3 obtained in the register 204 is a good approximation of a required value "$0 \leq M \bmod N \leq N-1$." However, it is larger than the required value by an integer multiple k of N (k is a small integer). This is corrected to obtain "$M \bmod N$." For example, the correction is done by sequentially reducing M3 by N. Then, M3 becomes negative at a certain point. The value just before becoming negative is a true solution of "$M \bmod N$."

This correction procedure may easily be realized with; ① a register 217 of Fig. 1 for storing N, ② a controller (not shown) for judging whether a value in the register 213 is positive or negative, ③ a bus for transferring a value in the register 204 to an output portion via the switch 214, etc.

In summary, the first embodiment of the present invention stores, with respect to base "a" numbers M each of "n" digits, remainders of "$X \cdot a^q \bmod N$" (the modulus N has "q" digits) in advance. Since the number of digits of the modulus N is "q," one remainder has merely "q" digits. On the other hand, the number of remainders to be stored is a function of the number "b" which is the number of digits of the divident X. Namely, there are "$a^b$" remainders. This "b" can be made smaller to reduce the size of the storage means to simplify the constitution and realize a high-speed remainder computation.

Figures 4 and 5 show another embodiment of the remainder computing system according to the present invention.

Similar to the first embodiment, a reference mark N represents a modulus, and M a dividend of n digits. Firstly, the divided M is set as M1. In the first embodiment, a block X1 of predetermined digits has been separated from the most significant bit of M1 to read a remainder of the block X1 out of a ram.

According to the second embodiment, the block X1 is divided into segments each of "S" digits. The segments are represented with X11, X12, X13 ...X1$\ell$ ($\ell$ = b/S). There are prepared "$\ell$" kinds of RAM$_j$ (j = 1 to $\ell$) corresponding to the respective blocks X1j (j = 1 to $\ell$) to store remainders R11 to R1$\ell$ corresponding to X1j.

To obtain M2 from M1 (M1 > M2), the remainders R11 to R1$\ell$ are aligned with a portion Z1 which is the remaining portion of M1 excluding the segments X11 to X1$\ell$, and they are added to each other sequentially. This alignment operation is done by aligning the least significant positions of the respective remainders R11 to R1$\ell$ with the "q"th position from the most significant position of the portion Z1. In this way, the second embodiment is realized on the basis of the method explained at the beginning of "DETAILED DESCRIPTION OF THE EMBODIMENTS" where on block of a dividend is divided into several segments each of S bits. The method of calculating remainders to be stored in the respective tables is the same as that explained at the beginning.

The added value is represented with a reference mark M2 which is successively processed with the same process as that for M1. Since the modulus is N, the process shall be repeated until the number of digits of Mj becomes smaller than the number of digits of N.

Figure 5 is a view showing an apparatus for finding a remainder according to the principle of the second embodiment. A reference mark "q" is the number of digits of N.

The apparatus shown in the figure comprises a computing unit 501 for carrying out the remainder computation and a storage unit (RAM) 502 having remainder tables storing remainders Rxj. Each of the remainders Rxj stored in the storage unit 502 is a remainder of a base "a" number Xj of "S" digits (the total number of the remainders is $a^s$), and the remainders are stored in "$\ell$" remainder tables 521, 522, ..., 52$\ell$.

How to look up the remainder tables in the "i"th iteration stage will be considered.

8

A dividend Mi is inputted into an input portion 503, written in a shift register 504 and left-justified in the register 504. An upper portion of "b (= $\ell$ • S)" digits of the dividend Mi stored in the register 504 are divided into segments Xi1 to Xi$\ell$ each of "S" digits, and these segments are used as data for looking up the remainder tables. Namely, a table lookup address A1j is prepared by concatenation of a value "j" from a counter 505 and a number Xj selected according to the value "j." For example, the firstly selected data X11 and a counter value 1 are latched to a latch circuit 508 which outputs a table lookup address A11 to the storage unit 502.

The storage unit 502 reads a remainder R11 corresponding to the segment X11 according to the address A11, out of the remainder table, and outputs the remainder R11 to a register 509.

On the other hand, after outputting the segment X11 to the selector 507, the segement X11 of upper "S" digits in the register 504 is cleared. Then, the upper "q" digits of a portion Z1 are transferred to an adder 511 via a selector 510. Here, the portion Z1 represents the remaining portion of the dividend M1 excluding the upper "b" digits for the segments X11 to X1$\ell$. In the adder 511, the remainder R11 from the register 509 and the upper "q" digits from the portion Z1 are added to each other, and the added result is outputted to a register 512. The value in the register 512 is again transferred to the adder 511 via a switch 514, a selector 513 and the selector 510.

After clearing the segment X11, the segment X12 is selected by the counter 505 and selector 507 and latched to the latch circuit 508 to output a table lookup address to the storage unit 502. The storage unit 502 outputs a remainder R12 corresponding to the address A12 out of the remainder table 516 to the register 509. In the adder 511, the remainder R12 from the register 509 and the previously added result from the selector 510 are added to each other, and the added result is outputted to the register 512. This operation is repeated up to the segment X1$\ell$.

The added result written in the register 512 is transferred to the shift register 504 via the switch 514 and selector 513 such that the "q+b"th position from the most significant bit of the contents of the shift register 504 is aligned with the least significant position of the added result. The lower "n-b-q" digits of the data in the shift register 504 are not affected by the above-mentioned operation. The contents of the shift register 504 thus obtained become a dividend M2 for the next processing stage.

The contents of the shift register 504 are shifted to the left until the most significant bit of the shift register 504 becomes 1. Namely, the dividend M2 is left-justified in the shift register 504. Then, the same operation as that for the first stage is carried out on the data M2. The upper "b" digits of the data M2 are divided into segments X21, X22, ..., X2$\ell$ each of "S" digits. A controller (not shown) checks to see whether or not the number of digits of the data M2 is larger than "q+b." If the data M2 is larger than "q+b," the data M2 is processed as a dividend with the similar procedures. This is repeated until the number of digits of data Mk becomes smaller than "q+b."

If the number of digits of the data Mk is smaller than "q+b" and the data Mk is larger than the modulus N, correction is made similar to the first embodiment until the data Mk becomes smaller than the modulus N but larger than 0. Namely, the modulus N stored in a register 506 is transferred to the adder 511 via the selector 510. Then, the data Mk is transferred to the adder 511 via the switch 514 and selectors 513 and 510. In the adder 511, the value N is subtracted from the data Mk so that the data Mk becomes smaller than the data N. The result is written in the register 512, and given to an output portion 515 via the switch 514 to complete the process.

In summary, according to the second embodiment of the present invention, optimum remainder tables can be set according to the sizes of modulus N and dividend M.

Various modifications will become possible for those skilled in the art after receiving the teachings of the present disclosure without departing from the scope thereof.

## Claims

1. A remainder computing system for computing a remainder (Ri) of a base "a" number (M1) of "n" digits with respect to a base "a" modulus (N) of "q" digits, said system comprising:

(a) a storage means storing remainders of base "a" numbers each of "b" digits with respect to the modulus (N), the number "b" being a predetermined number; and

(b) a means for separating a block (XI) of "b" digits from a most significant position of the number (M1) to leave a remaining portion (Z), finding a remainder (R1) corresponding to the block (X1) out of said storage means, aligning a least significant position of the remainder (R1) with a most significant position of the remaining portion (Z) to obtain a number (R1q), and adding the remaining portion (Z) to the number (R1q).

2. The remainder computing system as claimed in claim 1, further comprising:

(c) a transferring means for transferring a result of the addition of said separating and adding means as a new number (M2) to be processed.

3. The remainder computing system as claimed in claim 2, wherein said separating and adding means comprises;

a shift register (204) for holding the number (M1) to be processed;

a latch circuit (205) for latching the block (X1) of "b" digits from the most significant position of the number (M1) held in said shift register (204) and providing an address corresponding to the block (X1) to said storage means;

a register (208) and a switch (211), for transferring the remainder (R1) read out of said storage means according to the address;

a switch (216) for transferring the remaining portion (Z) from said shift register (204);

an adder (212) for aligning and adding the remainder (R1) from said switch (211) to the remaining portion (Z) from said switch (216); and

a register (213) for holding an added result from said adder.

4. The remainder computing system as claimed in claim 3, wherein said transferring means comprises:

a switch (214) for transferring, if the number of digits of the added result is larger than the predetermined number "b," the added result from said register (213) as the new number (M2) to be processed, and, if the number of digits of the added result is equal to or smaller than the number "b," outputting the added result as a final result.

5. A remainder computing method for computing a remainder (Ri) of a base "a" number (M1) of "n" digits with respect to a base "a" modulus (N) of "q" digits, said system comprising the steps of;

(a) separating a block (X1) of "b" digits from a most significant position of the number (M1) to leave a remaining portion (Z), the number "b" being a predetermined number;

(b) finding a remainder (R1) corresponding to the block (X1) with respect to the modulus (N) out of a storage means which is storing remainders of base "a" numbers each of "b" digits with respect to the modulus (N);

(c) aligning a least significant position of the remainder (R1) with a most significant position of the remaining portion (Z) to obtain a number (R1q); and

(d) adding the remaining portion (Z) to the number (R1q) to provide an added result.

6. The remainder computing method as claimed in claim 5, further comprising a step of:

(e) setting, if the number of digits of the added result is larger than the predetermined number "b," the added result as a new number (M2) to be processed and repeating said steps (a), (b), (c) and (d) on the new number (M2), and, if the number of digits of the added result is equal to or smaller than the number "b," outputting the added result as a final result (Ri).

7. A remainder computing system for computing a remainder (Ri) of a base "a" number (M1) of "n" digits with respect to a base "a" modulus (N) of "q" digits, said system comprising:

a storage means storing remainders of base "a" numbers each of "S" digits with respect to the modulus (N); and

a means for separating a block (X1) of "b" digits from a most significant position of the number (M1) to leave a remaining portion (Z), dividing the block (X1) into a plurality of segments (X11 to X1$\ell$) each of "S" digits, finding remainders (R11 to R1$\ell$) corresponding to the segments (X11 to X1$\ell$) out of said storage means, aligning least significant positions of the remainders (R11 to R1$\ell$) with the "q"th position from the most significant position of the remaining portion (Z) to obtain values (R11q to R1$\ell$q), and adding the remaining portion (Z) to the values (R11q to R1$\ell$q).

8. The remainder computing system as claimed in claim 7, further comprising:

a transferring means for transferring, if the number of digits of an added result of said separating and adding means is larger than the predetermined number "b," the added result as a new number (M2) to be processed, and, if the number of digits of the added result is equal to or smaller than the number "b," outputting the added result as a final result.

9. A remainder computing method for computing a remainder (Ri) of a base "a" number (M1) of "n" digits with respect to a base "a" modulus (N) of "q" digits, said system comprising the steps of:

(a) separating a block (X1) of "b" digits from a most significant position of the number (M1) to leave a remaining portion (Z), the number "b" being a predetermined number;

(b) dividing the block (X1) into a plurality of segments (X11 to X1$\ell$) each of "S" digits, the number "S" being a predetermined number;

(c) reading remainders (R11 to R1$\ell$) corresponding to the segments (X11 to X1$\ell$) with respect to the modulus (N) out of a storage means which is storing remainders of base "a" numbers each of "S" digits with respect to the modulus (N);

(d) aligning least significant positions of the remainders (R11 to R1$\ell$) with the "q"th position from a most significant position of the remaining portion (Z) to obtain values (R11q to R1$\ell$q); and

(e) adding the remaining portion (Z) to the values (R11q to R1$\ell$q) to provide an added result.

10. The remainder computing method as claimed in claim 9, further comprising a step of:

(f) setting, if the number of digits of the added result is larger than the predetermined number "b," the added result as a new number (M2) to be processed and repeating said steps (a), (b), (c), (d) and (e) on the new number (M2), and, if the number of digits of the added result is equal to or smaller than the number "b," outputting the added result as a final result (Ri).

$EP\ 308963$

1/5

# F I G . 1

N BITS

r1  r2  r3  Z1  ~M

Z1
R1
R2
R3

+)

M2

$$M_2 = R_1 + R_2 + R_3 + Z_1$$

FIG.2

FIG.3

# FIG.4

FIG.5